# EUROPEAN PATENT APPLICATION

(11) **EP 1 150 128 A1**
(43) Date of publication of application: **31.10.2001**
(21) Application number: 01303714.8
(22) Date of filing: 24.04.2001
(51) Int. Cl.: G01R 31/28, G01R 31/319

(54) **Inspection apparatus**

(30) Priority: 27.04.2000 JP 2000127845
(71) Applicant: Sony da Amazonia Ltda, Manaus, Amazonas (BR)
(72) Inventor: Maeda, Jaime Muneo Magalhaes, Manaux, Amazonas (BR); Da Silva, Agemilson Pimentel, Manaux, Amazonas (BR); Cabral, Fabio Cesar Oliveira, Manaux, Amazonas (BR); Pinheiro, Luis Savio, Manaux, Amazonas (BR); Silva, Odiletil Oliveira, Manaux, Amazonas (BR); Peres, Cesar Jose, Jr., Manaux, Amazonas (BR)
(74) Representative: Ayers, Martyn Lewis Stanley

(57) **Abstract**

An inspection apparatus capable of automatically inspecting a product, that is, an inspection apparatus capable of performing automatic measurement and automatic judgment is disclosed. An inspection apparatus consists of a recording medium (13), a personal computer (12), a digital signal processor (DSP) (11), and a display device (14). An inspection program is recorded in the recording medium (13). The inspection program recorded in the recording medium (13) runs in the personal computer (12). The digital signal processor (11) has its action controlled based on a command issued from the personal computer (12), feeds a predetermined inspection signal to predetermined points on an inspected product (2), and acquires a result-of-inspection signal. It is judged from the result-of-inspection signal whether the inspected product is acceptable. The result of judgment is displayed on the display device (14).

## Description

The present invention relates to an inspection apparatus suitable for being adapted to the inspection of a printed-circuit board in the process of manufacturing, for example, electronic equipment.

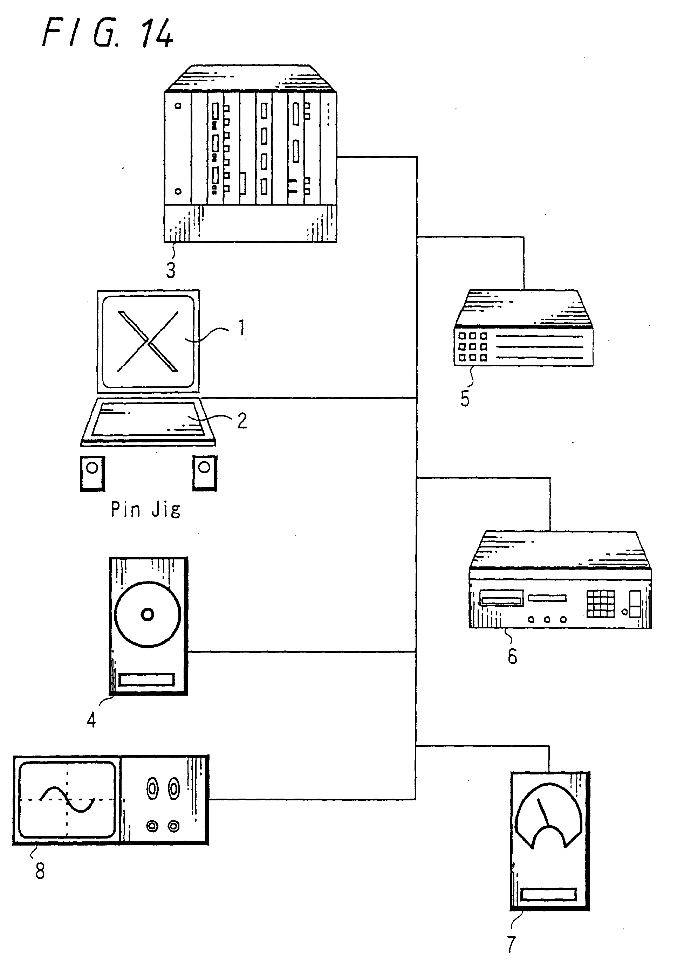

In the past, a configuration like the one shown in FIG. 14 of the accompanying drawings has been adopted in order to perform inspections including the inspection of a frequency-response characteristic and the inspection of a distortion factor in the process of manufacturing a printed-circuit board to be incorporated in electronic equipment or the like.

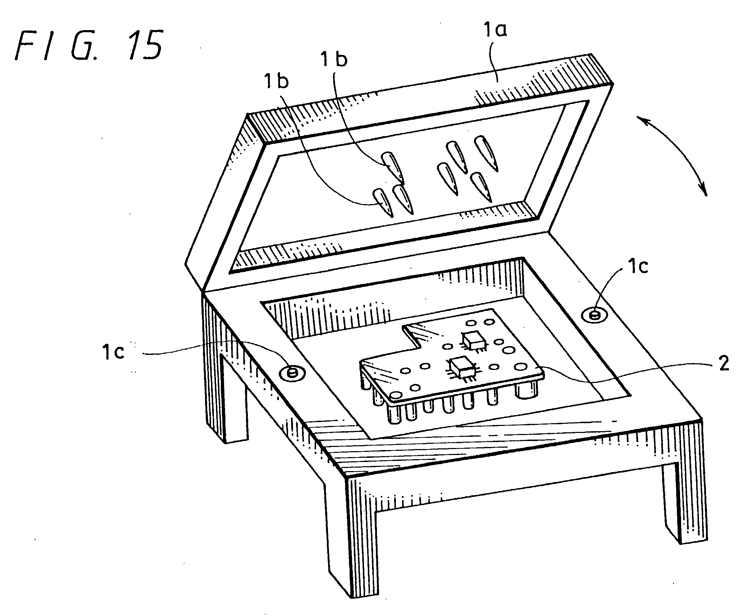

A description will be made with reference to FIG. 14. In FIG. 14, reference numeral 1 denotes a pin jig. As shown in FIG. 15, the pin jig 1 positions and locks a printed-circuit board 2 to be inspected, that is, an inspected product. A predetermined number of pins 1b serving as contacts are formed on an upper lid la. When the upper lid 1a is closed, the pins 1b come into contact with a predetermined number of test points on the printed-circuit board 2. Power, an inspection signal, or the like is fed through the pins 1b.

In FIG. 15, reference numeral 1c denotes a switch. When the upper lid 1a is closed, the switches 1c are turned on. At this time, an inspection is started.

The pin jig 1 is connected to a control box 3, a signal generator 4, a frequency meter 5, a distortion factor meter 6, a voltmeter 7, and an oscilloscope 8. The control box 3 instructs what inspection is to be performed, and achieves predetermined connections. The signal generator 4 generates an inspection signal dependent on the contents of inspection. The frequency meter 5 is used to inspect a frequency-response characteristic. The distortion factor meter 6 is used to measure a distortion factor. The voltmeter 7 measures a voltage. For example, for inspecting a frequency-response characteristic or a distortion factor, an operator controls the control box 3, and adjusts the signal generator 4 that generates an inspection signal. The operator checks a measured value read by the frequency meter 5 or distortion factor meter 6 so as to judge whether a printed-circuit board is acceptable.

In the foregoing conventional inspection system, a human being (operator) checks a measured value and adjusts the inspection system. There is therefore a possibility that the human being may make an incorrect judgment. Besides, there is a disadvantage that the meters 5, 6, and 7 must be calibrated before every measurement. Another disadvantage is such that all the meters must be checked in order to recognize their measuring situations.

When objects of inspection must be switched or inspection items must be changed, it takes much time to switch the various meters and perform setting for a meter employed. Besides, since many meters are used, a wide space is needed despite a small amount of production

Accordingly, an object of the present invention is to propose an inspection apparatus capable of automatically performing inspections, that is, performing automatic measurement and automatic judgment.

According to the present invention, an inspection apparatus consists mainly of a recording medium, a personal computer, a digital signal processor (DSP), and a display device. The recording medium has an inspection program stored therein. The personal computer has the inspection program, which is stored in the recording medium, run therein. The digital signal processor has its action controlled based on a command issued from the personal computer, feeds a predetermined inspection signal to predetermined points on an inspected product, and acquires a result-of-inspection signal. It is judged from the result-of-inspection signal whether the inspected product is acceptable. The display device displays a result of judgment.

According to the present invention, the digital signal processor (DSP) feeds the predetermined inspection signal to the predetermined points on the inspected product in response to the command issued from the personal computer, and acquires the result-of-inspection signal. The digital signal processor then judges from the result-of-inspection signal whether the inspected product is acceptable. Automatic measurement and automatic judgment are therefore possible, whereby automatic inspection is possible.

Embodiments of the invention will now be described, by way of example only, with reference to the accompanying drawings, in which:
FIG. 1 shows a configuration of an example of an inspection apparatus in accordance with the present invention;
FIG. 2 shows an example of a pin jig, FIG. 2A is a perspective view showing the pin jig with an upper lid opened, FIG. 2B is a sectional view of the pin jig shown in FIG. 2A, FIG. 2C is a perspective view showing the pin jig with the upper lid closed, FIG. 2D is a sectional view of the pin jig shown in FIG. 2C, and FIG. 2E is a perspective view showing an example of an operation switch box;
FIG. 3 shows a configuration of an example of a digital signal processor (DSP);
FIG. 4 is a flowchart useful in explaining the present invention;
FIG. 5 shows a configuration of another embodiment of the inspection apparatus in accordance with the present invention;
FIG. 6 shows a configuration of an example of a major portion of the inspection apparatus shown in FIG. 1;
FIG. 7 is used to explain the present invention;
FIG. 8 shows a configuration of an example of the major portion of the inspection apparatus in accordance with the present invention;
FIG. 9 is a flowchart useful in explaining the present invention;
FIG. 10 is used to explain the present invention;
FIG. 11 is used to explain the present invention;
FIG. 12 is used to explain the present invention;
FIG. 13 is a flowchart useful in explaining the present invention;
FIG. 14 shows a configuration of an example of a conventional inspection system; and
FIG. 15 is a perspective view showing an example of a pin jig.

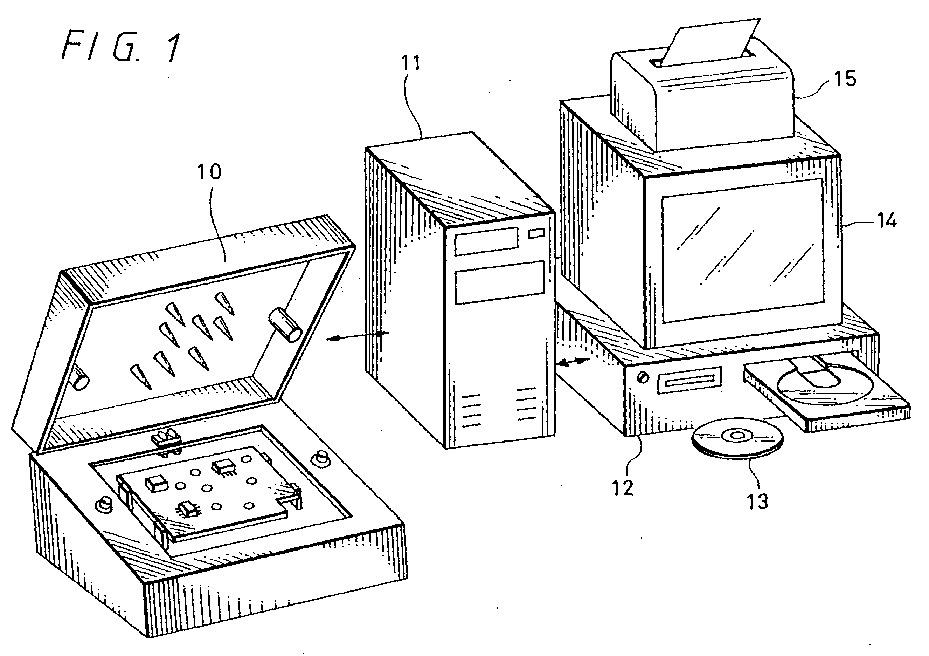

FIG. 1 shows an overall configuration of the inspection apparatus of this example. In FIG. 1, reference numeral 10 denotes a pin jig for positioning and locking a printed-circuit board 2 to be inspected, that is, an inspected product. Reference numeral 11 denotes a digital signal processor (DSP) for feeding an inspection signal to predetermined test points on the printed-circuit board 2 to be inspected which is positioned and locked in the pin jib 10. The digital signal processor 11 acquires a result-of-inspection signal. Reference numeral 12 denotes a personal computer (PC) for issuing a command to the digital signal processor (DSP) 11 according to an inspection program and receiving the result-of-inspection signal from the digital signal processor (DSP) 11.

Reference numeral 13 denotes a recording medium, for example, a CD-ROM. An inspection program according to which the printed-circuit board 2 is inspected is stored in the CD-ROM 13. Reference numeral 14 denotes a display device on which a result of inspection, a process thereof, or a situation thereof sent from the personal computer 12 is displayed. Reference numeral 15 denotes a printer for producing a printout of the result of inspection.

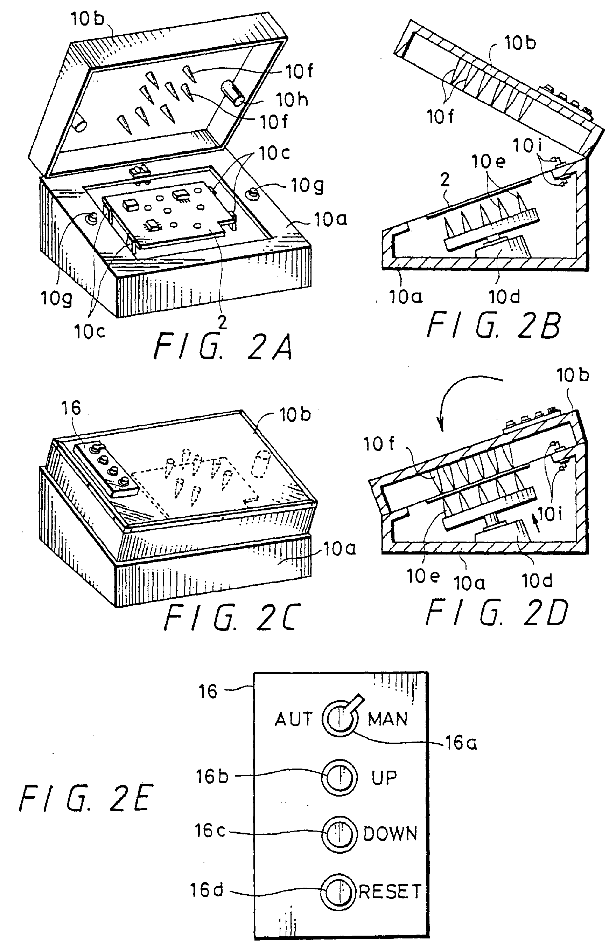

The pin jig 10 of this example is structured as shown in FIG. 2. FIG. 2A is a perspective view showing the pin jib 10 with an upper lid 10b opened. FIG. 2B is a sectional view of the pin jig 10. FIG. 2C is a perspective view showing the pin jig 10 with the upper lid 10b closed. FIG. 2D is a sectional view of the pin jig 10.

The pin jig 10 has a support member 10c, which supports the printed-circuit board 2 to be inspected, formed on a body 10a of the pin jig 10. A predetermined number of pins 10e serving as contacts are formed in the body 10a so that they can be vertically moved using a cylinder 10d. When the pins 10e are moved upwards, they come into contact with test points formed on the lower side of the printed-circuit board 2.

The upper lid 10b is formed of a transparent plate, for example, an acrylic plate so that the interior can be seen through the upper lid. A predetermined number of pins 10f serving as contacts is formed on the inner side of the upper lid 10b. When the upper lid 10b is closed, the tips of the pins 10f come into contact with the predetermined test points on the printed-circuit board 2. Through the pins 10e and 10f, power, an inspection signal, or the like is fed and a result-of-inspection signal or the like is acquired.

In FIG. 2, reference numeral 10g denotes a connection switch. When the upper lid 10b is closed, the connection switches 10g are brought into contact with pins 10h formed on the upper lid 10b and turned on. When the connection switches 10g are turned on, the cylinder 10d causes the pins 10e to ascend. Consequently, the pins 10e come into contact with the test points on the printed-circuit board 2. An inspection is then started.

Moreover, reference numeral 10i denotes a light-emitting diode located at an internal predetermined position in the pin jig 10. Depending on the light-emitting diodes 10i, a light receiver included in a remote control unit mounted on the upper side or lower side of the printed-circuit board 2 may be inspected. Otherwise, the printed-circuit board 2 or any other measured object may be controlled based on a remote control signal, and an operation mode to which the printed-circuit board 2 or any other measured object is set may be changed to another according to the conditions for measurement.

An operation switch box 16 to be manipulated by an operator for controlling the inspection apparatus is placed on the top of the upper lid 10b of the pin jig 10. The operation switch box 16 has, as shown in FIG. 2E, an Auto/Manual switching button 16a, an Up button 16b, a Down button 16c, and a Reset button 16d. The Auto/Manual switching button 16a is used to switch automatic and manual execution modes. The Up button 16b is used to instruct the inspection apparatus to pass control to the next step. The Down button 16c is used to instruct the inspection apparatus to return control to a previous step. The Reset button 16d is used to instruct the inspection apparatus to suspend inspection and return to its initial state.

The automatic mode is a mode in which the steps of an inspection program are, as described later, automatically executed one by one. The manual mode is a mode in which the steps of the inspection program are executed responsively to a manipulation performed on the operation switch box 16 by an operator.

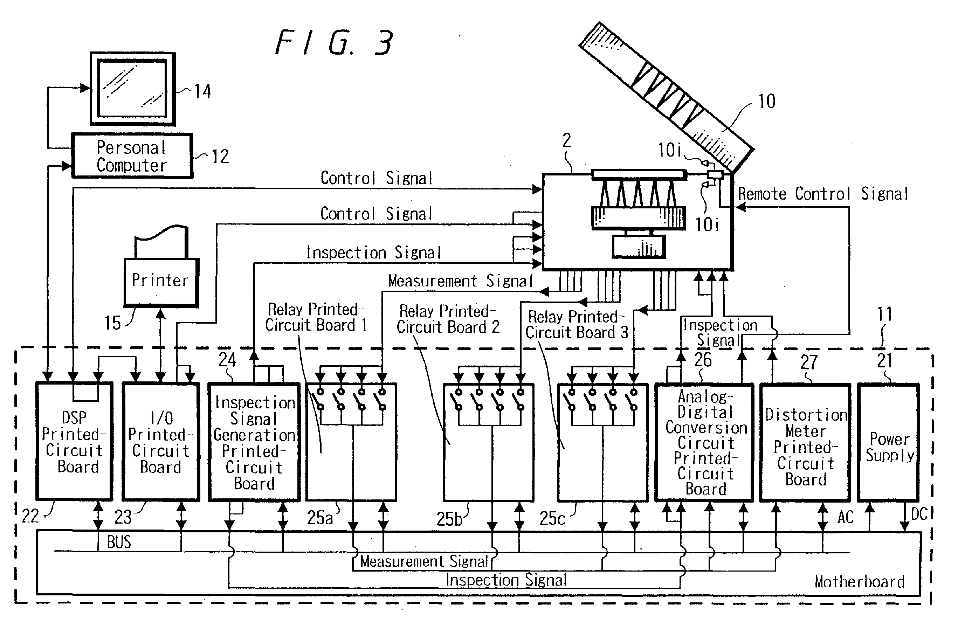

FIG. 3 is a block diagram showing an example of the configuration of the digital signal processor (DSP) 11. Referring to FIG. 3, the digital signal processor (DSP) will be described below.

In FIG. 3, reference numeral 20 denotes a motherboard. The motherboard 20 interconnects other printed-circuit boards and a power supply which are incorporated in the digital signal processor (DSP) 11. A power supply 21 in the DSP 11 supplies voltages of - 5 V, + 5 V, - 12 V, and + 12 V.

In this example, a digital signal processor (DSP) printed-circuit board 22, an input/output (I/O) printed-circuit board 23, an inspection signal generation (ASG) printed-circuit board 24, three relay printed-circuit boards 25a, 25b, and 25c, an analog-digital conversion circuit (ADC) printed-circuit board 26, and a distortion meter printed-circuit board 27 are inserted in board connectors placed on the motherboard 20. A bus, a measurement signal line, a second measurement signal (video signal) line, a line for an inspection signal sent from the inspection signal generation (ASG) printed-circuit board 24, other signal lines, and a power line are coupled to each of the board connectors.

The DSP printed-circuit board 22 is the brain of the digital signal processor 11(DSP). A processor TMS-302C31 manufactured by Texas Instrument Corp. and responsible for digitization of data sent from the inspection apparatus is mounted on the DSP printed-circuit board 22 together with a logic matrix programmer chip TIBPAL-22V10. A communication interface is interposed between the parallel port of the personal computer 11 and the processor TMS.

The DSP printed-circuit board 22 controls all the printed-circuit boards incorporated in the DSP 11, that is, the I/O printed-circuit board 23, inspection signal generation (ASG) printed-circuit board 24, relay printed-circuit boards 25a, 25b, and 25c, ADC printed-circuit board (multi-meter printed-circuit board) 26, and distortion meter printed-circuit board 27. Programs that can execute routines which are described below and according to which all the printed-circuit boards 23 to.27 are controlled are stored in a memory mounted on the DSP printed-circuit board 22.

The routines executed in the DSP 11 include a measurement (inspection) routine, an oscillator routine, a routine for a remote control signal (for example, SIRCS code), and a distortion routine.

The measurement (inspection) routine measures a frequency or a voltage. According to the routine, a relay is selected from any of the relay printed-circuit boards 25a, 25b, and 25c, and an inspection signal is fed to the ADC printed-circuit board (multi-meter printed-circuit board) 26 via the relay.

The oscillator routine selects an inspection signal, which exhibits a predetermined level and has a predetermined frequency, according to an inspection program run in the personal computer 12.

The routine for a remote control signal produces a remote control signal (for example, SIRCS code) and transmits the remote control signal to the infrared light-emitting diodes 10i included in the pin jig 10.

The distortion routine performs fast Fourier transform to calculate a signal distortion (FFT).

The DSP printed-circuit board 22 accommodates a floating point unit, a logic arithmetic unit, and an auxiliary register for the DSP 11. An extension memory can be connected to the DSP printed-circuit board 22 through an interface included in the DSP printed-circuit board 22. The DSP printed-circuit board 22 has sixteen chip select lines for controlling the other printed-circuit boards and a buffer bus which are incorporated in the DSP 11. A connector is connected to a parallel port of the personal computer 12. A bus, for example, an I²C bus is coupled to the connector.

The input/output (I/O) printed-circuit board 23 carries three PPIs-8255. Two ports are free to be programmable as it feels more convenient. Where 4 ports (8 bits each) will be destined to writing and 2 ports to reading. The software will have some more applications of how to use these ports. One of them will use input of 4 bits for reading and one standard JIG key board, interpreting the pressing of 4 keys of JIGS operation on the production line (UP-pass, DOWN-back, RESET-start, and MAN/AUT-indicating manual or automatic JIGs operation).

Various number of other applications, for example, a switching driver, controlling of another external printed-circuit board, a simulation of communication protocols, and a serial or parallel communication program are available. Moreover, a digital unit or some micro-controllers are available.

The I/O printed-circuit board 23 communicates with the matrix printer 15 according to a protocol produced based on a standard protocol. A bus extended from the printed-circuit board 23 through a 25-pin connector is led to a connector usable in a board room. The printer 15 is located at the end of a manufacturing line, and used to record an error or incompatibility detected during inspection and to produce a printout of a point or a result of executed measurement.

A PPI 8255 handles a signal sent over the I²C bus, a signal SDA, a clock CLK and its control signal, and signals INT and RST. These signals are usable through a connector connected to the DSP printed-circuit board 22 or a connector prepared by a user.

The inspection signal generation (ASG) printed-circuit board 24 produces five different waves, that is, a sine wave, an exponential wave, a triangle wave, a ramp wave, and the like. In a frequency band ranging from 1 Hz to 65535 Hz, an output of 3.5 Vrms is developed at pin 27 despite an output impedance of about 600. Control is given by a PPI 8255. The PPI feeds 16-bit data and a control bit that are required for a frequency change, and signals W1 and W2, T1, T2, T3, and T4, CLOCK-OUT, CLK-OUT, and CLK-IN, and RST. The produced signal components are multiplexed based on stereo recording and assigned to eight outputs through a connector P5. An attenuation level can be changed from - 80 dB (100 *µ*V) to 11 dB (3.5 V) with 0 dB (1V) set as a reference level.
(1) D0 to D15 (pins 1 to 16): these pins function as a data input port. D15 is the most significant bit.
(2) W1 and W2 (pins 17 and 18): these pins are used to select a wave.
(3) T1, T2, T3, and T4 (pins 19 to 22): these pins indicate signal phases of 0(, 90(, 180(, and 270(.
(4) CLK-IN (pin 23): this is a clock input pin.
(5) CLK-OUT (pin 24): this is a clock output pin and must be connected to CLK-IN.
(6) CLK-OUT (pin 25): this pin inhibits output of a clock.
(7) RST (pin 26): this pin provides a reset signal and remains high logic level while the oscillator is in operation.
(8) OUT (pin 27): this pin provides an output of the oscillator.
(9) GND (pin 28): this pin grounds an output signal.
(10) 0V (pins 29, 30, 33, and 34): these pins provide a voltage of a reference level.
(11) +5V (pins 31 and 32): this pin provides a direct voltage of + 5 V.
(12) -Vcc (pins 35 and 36): these pins provide a direct voltage of - 12 V.
(13) +Vcc (pins 37 and 38): these pins provide a direct voltage of +12 V.

The relay printed-circuit boards 25a, 25b, and 25c are intended to multiplex 24 input channels, which are used for measurement and sent from a multi-meter printed-circuit board which is an analog-to-digital conversion circuit (ADC) printed-circuit board 26, on an A/D channel. As the name implies, switching of the channels is achieved by switching relay contacts, and controlled by a PPI-8255. The contacts in the relay printed-circuit board are switched based on a signal (8 bits long) output from each port of the PPI-8255. Twenty-four signal components output from the relay printed-circuit boards 25a, 25b and 25c are input to the PPI through three ports. This system includes three relay printed-circuit boards. The three relay printed-circuit boards 25a, 25b and 25c are strapped (connected) therebetween, whereby the measurement channels can be multiplexed.

Strap 1: selected by CS8 for passing channels 1 to 24.

Strap 2: selected by CS9 for passing channels 25 to 48.

Strap 3: selected by CS10 for passing channels 49 to 72.

Consequently, up to 72 measurement channels are provided on the system through 36-pin connectors on the three relay printed-circuit boards forming the relay printed-circuit boards 25 and one channel may be selected from between the above 72 channels as a measuring signal. One of the three relay printed-circuit boards 25a, 25b and 25c or a part of 24 channels on the one relay printed-circuit board may be selected apart from the other components to output in another way, for example, to select video signals simultaneously.

The analog-to-digital conversion circuit (ADC) printed-circuit board 26 is based on an analog-to-digital (A/D) converter 37 designed to offer a resolution of 12 bits to read AC signal with rms circuit 35. The A/D converter 37 operates in a unipolar, bipolar, or any other mode, reads a positive or negative signal ranging from - 10 V to + 10 V. A produced timing signal fCLK has a frequency of 2 MHz, and a conversion time tconv is 0.5 (sec. A power supply of + 5 V is employed irrespective of the unipolar mode or bipolar mode.

The ADC printed-circuit board 26 provides six input channels for measurement. One of the input channels is used as an input to be fed to a test system via the relay printed-circuit board 25. The second input channel is fed to a distortion meter printed-circuit board 27, and the other input channels are dedicated to measure the power applied to the system.

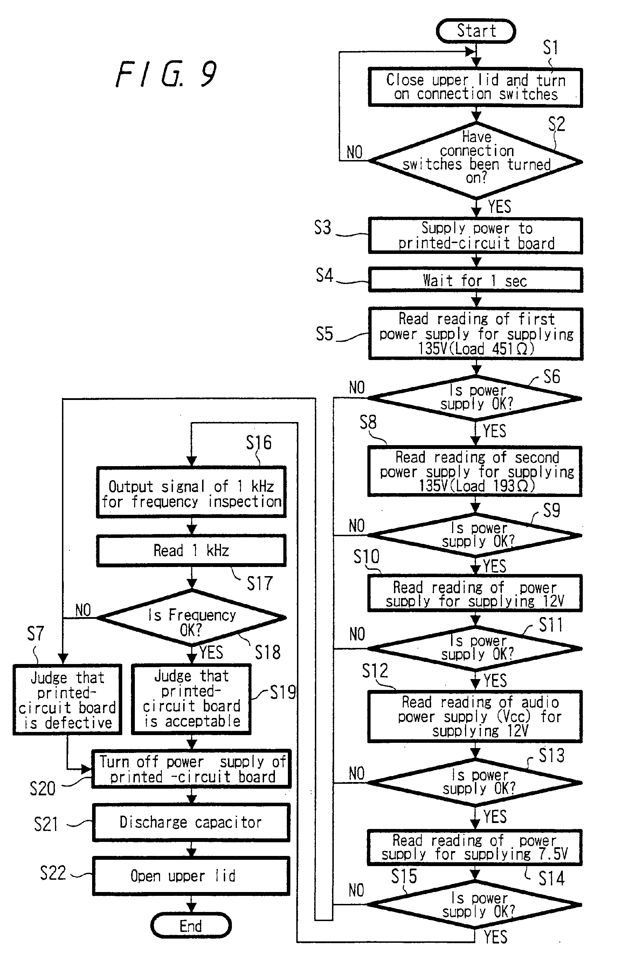

The ADC printed-circuit board 26 includes an amplifier circuit 32 as shown in FIG. 8, that amplifies the magnitude of an input signal which responds to a test result to provide an output signal whose magnitude is up to 1000 times larger than that of the input signal. The amplifier circuit can be programmed in four different manners, that is, to amplify the magnitude of an input signal at a magnification of 1, 10, 100, or 100. For example, a low-level signal that is as low as, for example, 1 mV can be measured. Alternatively, the ADC printed-circuit board 26 is provided with a resistance attenuation circuit 30, as shown in FIG. 8, which can be programmed to offer a magnification of 1, 1/5, 1/20, and 1/100 and can read a voltage of up to 1000 V. However, for the reason of safety, a recommended maximum voltage is 800 V for a typical action. At this time, a margin for the A/D conversion circuit 37 is set to 20 %.

In any case, to an extreme, the ADC printed-circuit board 26 includes a protection circuit 31 realized with a cut diode (for feeding excessive current to a power supply) and a protection chip. This protection chip retains an output at 12 V despite an input of 12 V or higher. The upper limit of the input voltage of the chip is 40 V. Attenuation software is, according to a formal initial measurement sample, devised to automatically adjust a required attenuation level. The protection chip has a property of a high conversion rate to enable quick and efficient digitization. When the chip is connected to the protection circuit 31, the fitness of a measuring system included in the inspection apparatus is guaranteed.

A movable contact 33a of a change-over switch 33 for changing-over a frequency measurement mode and a voltage measurement mode is provided at an output side of an amplifier circuit 32 in the measurement line and a fixed contact 33c at the side of frequency measurement of the change-over switch 33 is connected to a frequency measurement circuit 38 to measure a frequency and to supply the frequency measurement signal to a DSP printed-circuit board 22. This is programmed as a counter and a level transition is counted every 500 msec, to provide a pulse quantity, therefore a frequency. The range covers up to 300 kHz. However, the range may be enlarged in response to a need of users.

A fixed contact 33b at a voltage measurement side of the change-over switch 33 is connected with a movable contact 34a of an AC-DC change-over switch 34, and a fixed contact 34b at the AC side of the change-over switch 34 is connected with an effective value circuit 35 to provide a mean-square value of AC voltage by this effective value circuit 35. The mean-square value of the AC voltage is supplied to an A/D converter 37 via a buffer circuit 36.

An output signal of the A/D converter 37 is sent to a DSP printed-circuit board 22, where the output signal is estimated based on a maximum value and a minimum value, which are predetermined by a user.

A remote control code (for example, SIRCS code) generation circuit is arranged in the ADC printed-circuit board 26 and may be modulated by a reference modulation frequency for 39 kHz remote control, but may not be modulated. The code generation is executed by e.g. PPI8255 from the DSP printed-circuit board 22 in a clock generator mode.

An attenuator circuit 30, an AC/DC changing-over switch 34 and a frequency/voltage changing-over switch 33 are controlled by the PPI8255. All these switches are controlled by the relays.

A distortion meter printed-circuit board 27 is one which a processing for obtaining a signal distortion is performed by means of a fast Fourier transform method (FFT).

Table 1 denotes map addresses in the above-noted inspection apparatus in accordance with the present invention.

**Table 1**

| CS | 1.C | BOARD | PA | PB | PC |
|---|---|---|---|---|---|
| CS0 | PPI | Oscilator | Oscilator's Sup. Byte | PB0, PB3-channels | Oscilator's Inf. Byte |
| | | | | PB4,PB5-L/R | |
| | | | | PB6,PB7-wave type | |
| | | | 0X000000 | 0X000001 | 0X000002 |
| CS1 | Latch | Oscilator | PO,RST | | |
| | | | P1-OLK | | |
| | | | | | |
| | | | | | |
| | | | 0X00020 | | |
| CS2 | PPI | Multimeter | PAO,PA2-ATT | PBO-Bit Sircs | FREE |
| | | | PA3-ON/OFF | PB1-Hcount | |
| | | | PA4-AC/DC | | |
| | | | PA5-CH GND | | |
| | | | PA6,PA7-PGA gain | | |
| | | | 0X000040 | 0X000041 | 0X000042 |
| CS3 | Latch | Distortion | switching | | |
| | | | 0X000060 | | |
| CS4 | PPI | I/O | OUT1 | OUT2 | IN1 |
| | | | 0X000080 | 0X000081 | 0X000082 |
| CS5 | PPI | I/O | OUT3 | OUT4 | IN2 |
| | | | 0X0000A0 | 0X0000A1 | 0X0000A2 |
| CS6 | PPI | I/O | DATA PRINTER | PB0-SIB,FB1-Reset | PCO ERROR, PC1-BUSY |
| | | | | PB2,PB3-Free | PC2-OnLinePC 3 -Free |
| | | | | PB4-Int, PB5-Enable (I²C) | PC4-EOP,PC5-ACK |
| | | | | PB6-SDAOUT | PC6-SDAIN(I²C) |
| | | | | PB7-SCLOUT | PC7-SCLIN |
| | | | 0X000000 | 0X000001 | 0X000002 |
| CS7 | A/D | Multimeter | | | |
| | | | 0X0000E0 | | |
| CS8 | PPI | RELAY1 | R1aR8 | R9aR16 | R17aR24 |
| | | | 0X000100 | 0X000101 | 0X000102 |
| CS9 | PPI | RELAY2 | R25aR32 | R32aR40 | R41aR48 |
| | | | 0X000120 | 0X000121 | 0X000122 |
| CS10 | PPI | RELAY3 | R49aR56 | R57aR64 | R65aR72 |
| | | | 0X000140 | 0X000141 | 0X0000142 |
| CS11 | | 0X000160 | FREE | | |
| CS12 | | 0X000180 | FREE | | |
| CS13 | | 0X0001A0 | FREE | | |
| CS14 | | 0X000100 | FREE | | |
| CS15 | | 0X0001E0 | FREE | | |

An inspection program run in the inspection apparatus according to an embodiment of the present invention consists of three portions.
1) Low-level codes that are incorporated in a microprocessor (TMS) and stored in the DSP memory 22 through a HOST communication device.
2) Communication driver compatible with the Windows system, including a TMS assembly, and being DDL-formatted.
3) A program adaptable to the inspection apparatus includes an editor and an executable program and is complied into Delphi 4.0 under a Windows environment.

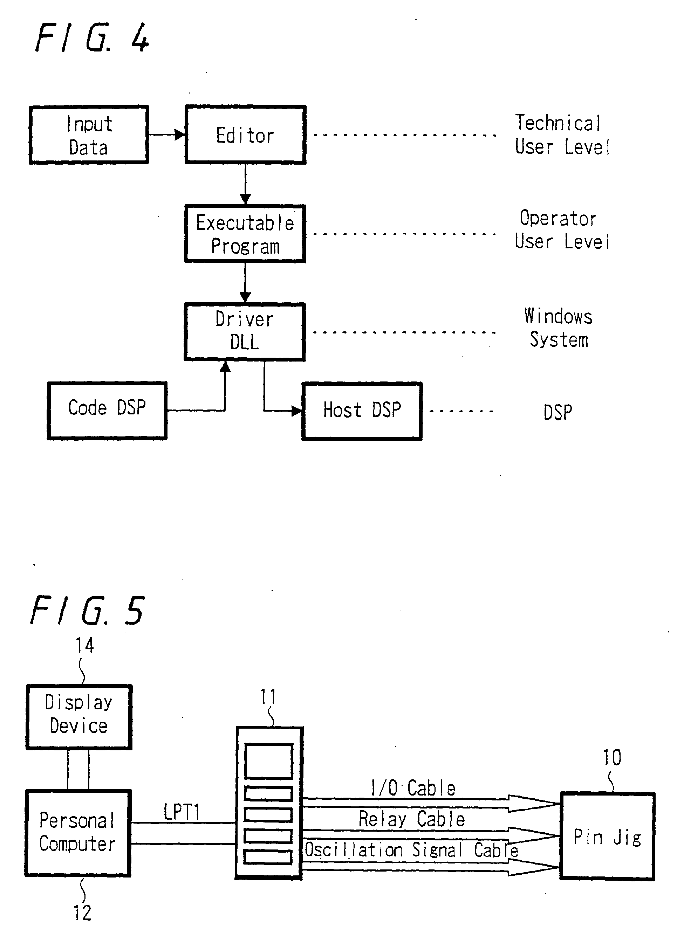

FIG. 4 is a flowchart of the inspection program. Levels at which the inspection program is handled are indicated on the right-hand side in FIG. 4.

At the first level, a user's environment or a client's environment is applied to the inspection system. In other words, a user uses an editor to enter for a test of this inspection system. Any other system that must be controlled is adaptable to the inspection system.

A user's program is reserved in an archive referred to as a VIR. The program specifies a testing sequence. A multi-meter, a frequency meter, and a protocol or the like are needed. The archive is activated according to an automatic format or a manual format (step by step). The levels at which the inspection program is handled are determined on the assumption that a use's environment is bases on the Windows.

The personal computer 12 is connected with the DSP device 11 by a set of parallel ports (LPT1) as shown in FIG. 5. The DSP device 11 is connected with a pin jig 10 by means of an I/O cable for transferring a control signal directed to the pin jig 10; a relay cable for transmitting a signal to be measured which is selected at a relay printed-circuit board 25; and an oscillation signal cable for transmitting an inspection signal produced at an inspection signal producing printed-circuit board 24.

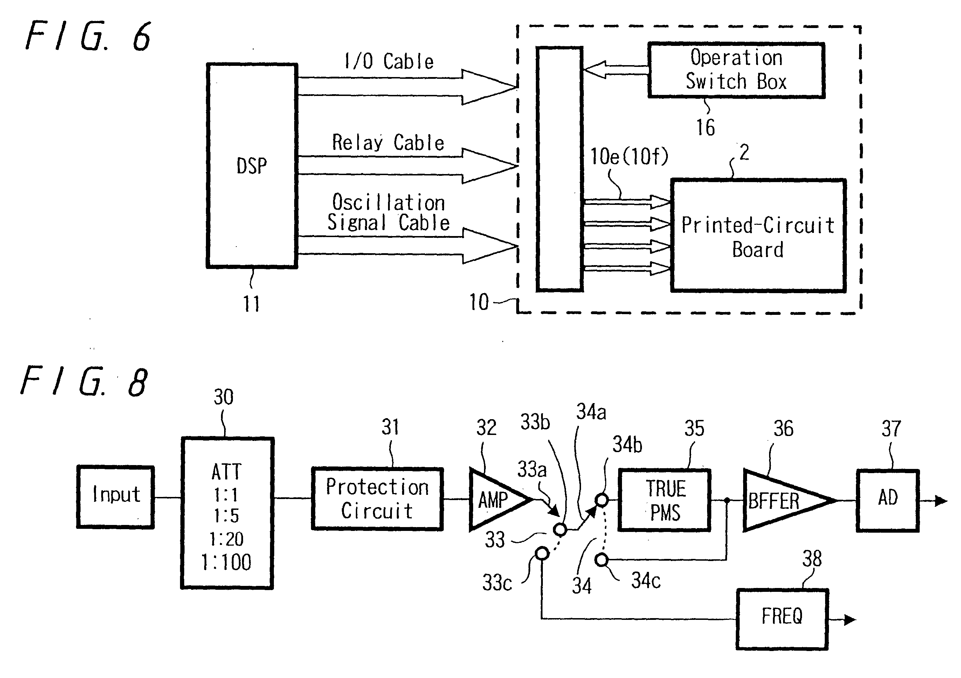

As shown in FIG. 6, a printed-circuit board 2 to be inspected is arranged in the pin jig 10 and a set of pins 10e (10f) forming a contact are united with a test point of the printed-circuit board 2 and the test point and the DSP device 11 are connected by a wire.

An example of the inspection with an inspection with an inspection unit according to the present invention will be described hereinafter. Before a printed-circuit board 2 for an audio device which is a subject for inspection to be inspected, is inspected, an operator inspects the inspection unit per se.

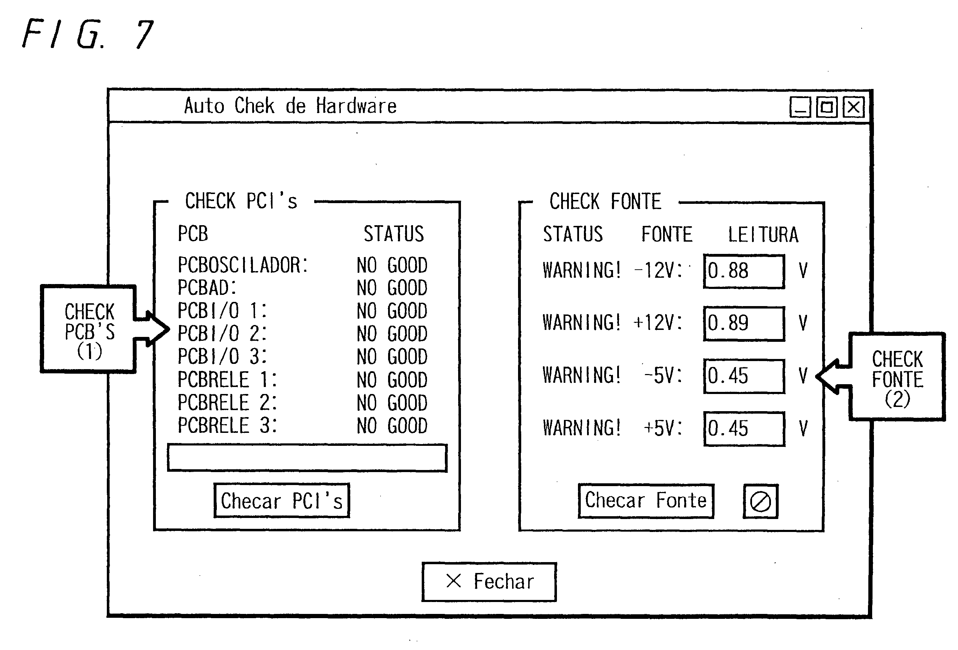

In this inspection, a first inspection checks whether a DSP unit 11 may include each printed-circuit board (23 - 27) as a first inspection process. If the printed-circuit boards 23-27 are not connected therewith, a display unit 14 indicates a warning of "NO GOOD" on the screen as shown in FIG. 7, while if each printed-circuit board 23 - 27 are connected correctly, data of "OK" will be shown on the screen.

As a second inspection process, several power sources (+5V, -5V, +12V, -12V), which are used by the DSP unit 11, are checked. If the power source is not proper, a caution of "Warning!" is indicated on the screen of the display unit 14 as shown in FIG. 7. If the power source is proper, a notification will be indicated to this effect. An inspection of the inspection unit per se is very useful to detect a fault of the inspection unit.

By means of the inspection unit according to the present invention, a power source voltage and a frequency characteristic. of a printed-circuit board 2 for audio devices is inspected automatically. Such example will be described using flow charts of FIGS. 8 and 9 which are the functional block diagrams of ADC printed-circuit boards 26 (for a multi-meter).

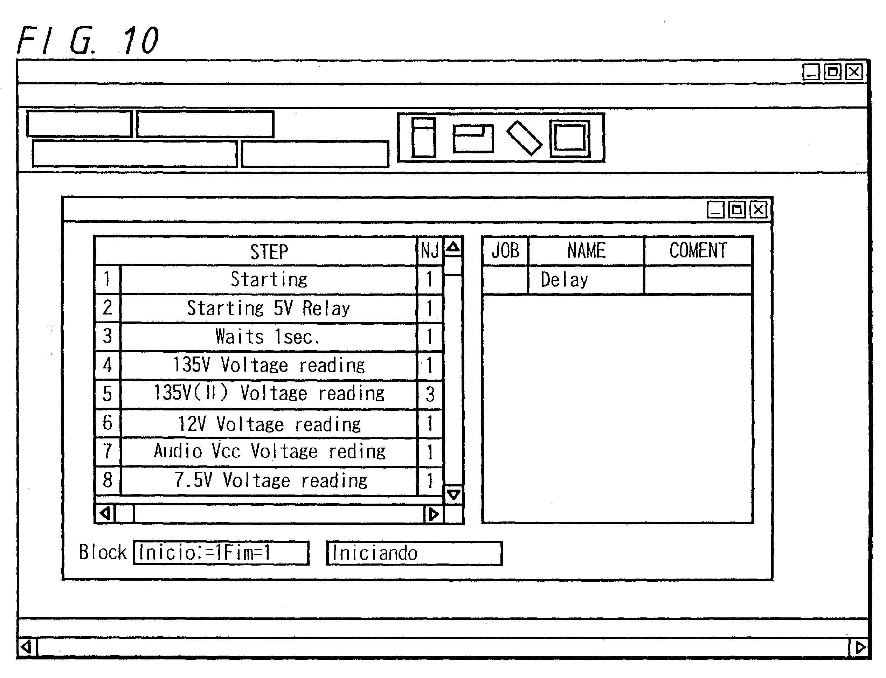

When inspected automatically, an automatic/manual change-over button 16a of an operative switch unit 16 mounted on an upper lid 10d is set to the automatic side and a pin jig 10 positions and locks a printed-circuit board 2 to be inspected. The printed-circuit board 2 is held to a retainer 10c of the pin jig 10 and then the upper lid 10b is closed to turn on a connection switch 10g (Step S1). Then the process shifts to a step S2 to judge whether or not the connection switch 10g may be turned on. Then, a screen image shown in FIG. 10 is displayed on the display unit 14.

When the connection switch 10g is turned on, a voltage 5V is applied to the printed-circuit board 2 for inspection (Step S3). Thereafter wait for one second (Step S4). Then, a first voltage of 135V is read (Step S5) at a value 451 Ω(ohms) of a load.

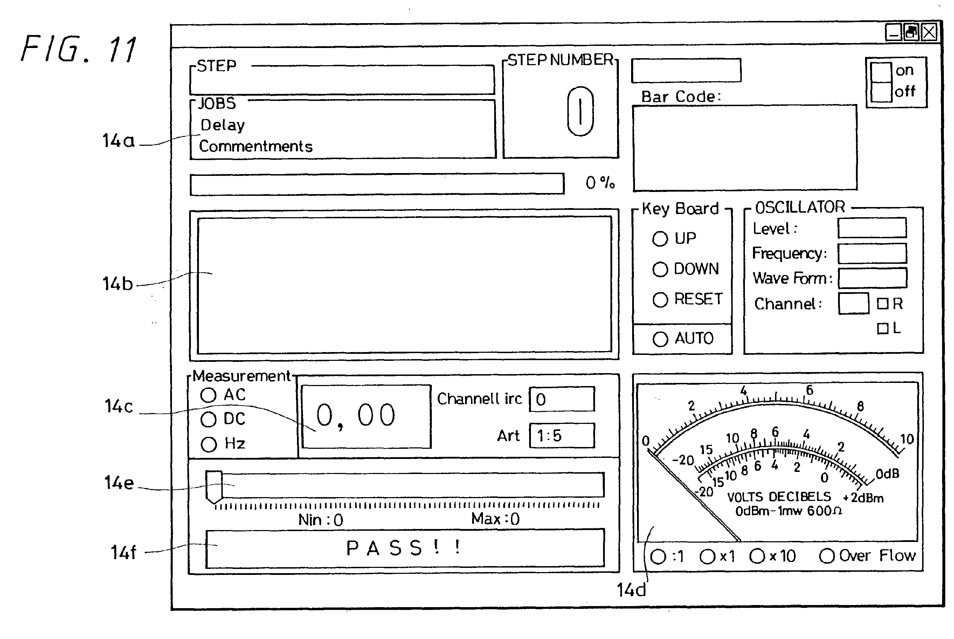

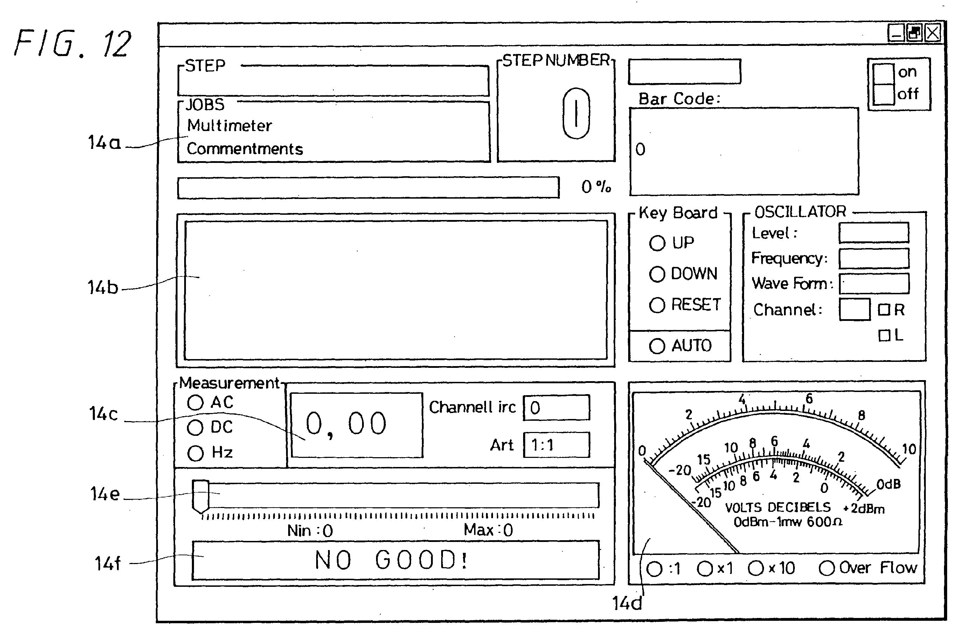

Next, judge whether or not, the above read voltage may be contained between a predetermined maximum and minimum (Step S6). When included in the range, the process is judged to be "PASS" and an image shown in FIG. 11 is indicated on the display unit 14; when not included in the range, the process is judged to be "NO GOOD" and an image shown in FIG. 12 is indicated on the display unit 14.

When NO GOOD, a screen of the display unit 14 is displayed, for example, by red, thus warn to be NO GOOD. On this case of NO GOOD in the automatic inspection, 20 times of reading are repeated and even when yet NO GOOD, the process is determined to be NO GOOD. In this flow chart when judged to be NO GOOD, after twenty times of repetitive readings, the process should be judged to be NO GOOD.

In FIG. 11 and FIG. 12, 14a displays a step that are present inspection program is executed, 14b shows a message for an operator, 14c shows a value that a read-out value (measured value) is displayed digitally, 14d shows a value that the read-out value (measured value) is displayed analogously, 14e shows the range which is referred to as PASS and 14f shows a judgment whether it is PASS or NO GOOD.

When judged to be NO GOOD in the step S6, the inspected printed-circuit board 2 is referred to as NO GOOD and further inspection cannot be performed (Step S7). When judged to be PASS in the step S6, the process shifts to the following inspection to effect reading of the second 135V power source (Step S8). In the reading of the second 135V power source, a load is 193 Ω(ohms).

Next, judge whether or not the read power source voltage may be included in the range between the predetermined maximum value and minimum value (Step S9). When included in the range, the process is "PASS", while not included in the range, the process is "NO GOOD". In this case, the indication of the display unit 14 is the same as mentioned above.

In the case of NO GOOD in the step S9, the process shifts to Step S7, and in the case of PASS, the process shifts to the next inspection to read a voltage of the 12V power source (Step S10).

Next, judge whether or not the read power source voltage may be included between the predetermined maximum and minimum valued (Step S11). When included between the maximum and minimum valued, the process is referred to as PASS, and otherwise, the process is referred to as NO GOOD. The indication of the then display unit 14 is the same as shown in the above.

In the case of NO GOOD in the step S11, the process shifts to Step S7, while in the case of PASS, the process shifts to the next inspection to read a voltage VCC of 12V power source in an audio device (Step S12).

Then judge whether or not the read power source voltage may intervene between the predetermined maximum and minimum values (Step S13). When intervened within the above range, the process is referred to as PASS and otherwise, the process is referred to as NO GOOD. The indication of the then display unit

In the case of NO GOOD in the step of S13, the process shifts to the Step S7, while in the case of PASS, the process shifts to the next inspection to read a voltage of 7.5 V power source (Step S14).

Then, judge whether or not the read power source voltage may intervene between the predetermined maximum and minimum values (Step S15). When intervened within the above range, the process is referred to as PASS and otherwise, the process is referred to as NO GOOD. The indication of the then display unit 14 is the same as shown in the above.

In the case of NO GOOD in the step of S15, the process shifts to the step S7, while in the case of PASS, the process shifts to the next inspection where 1kHz of signal is oscillated for inspecting a frequency (Step S16). Then, a signal of 1kHz is read (Step S17).

Then, judge whether or not the read frequency may intervene in the range between the predetermined maximum and minimum values (Step S18). When intervened within the above range, the process is referred to as PASS and other wise, the process is referred to as NO GOOD. The indication of the then display unit 14 is the same as shown in the above.

In the case of NO GOOD in the step of S18, the process shifts to the Step S7, while in the case of PASS, the process regards the printed-circuit board as PASS (Step S19). In the case of PASS in the step of S18 and in the case of NO GOOD in the step of S7, the process shifts to the S20, to turn off the power source of the printed-circuit board, a capacitor of the printed-circuit board is discharged (Step S21). Thereafter an upper lid 10b of the pin jig 10 is opened to takeout the printed-circuit board, thereby the inspection has been completed.

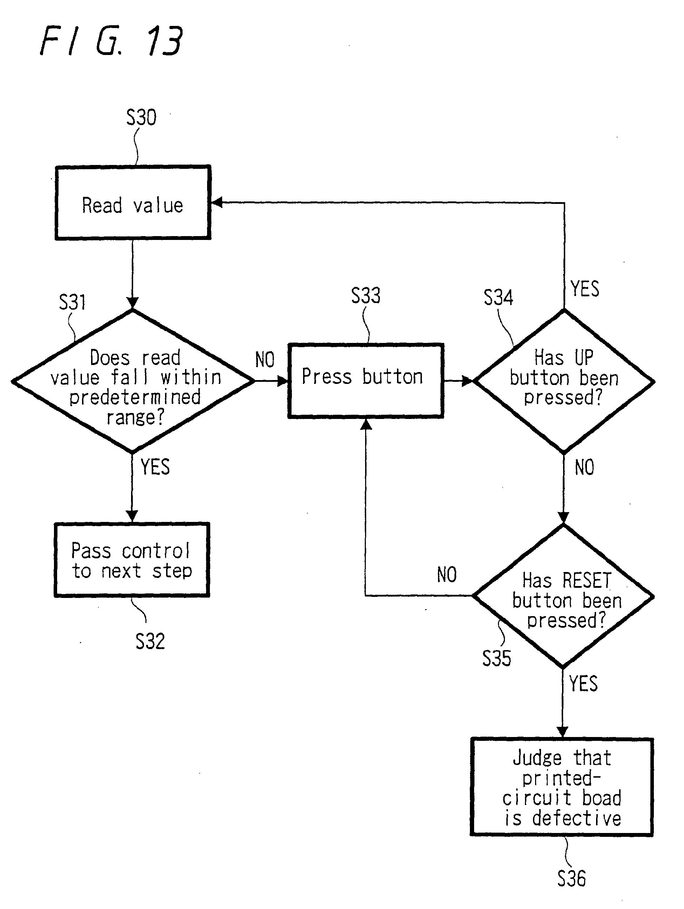

The above-noted example describes a case of automatic inspection. Next, using an operational switch unit 16 which is mounted on an upper lid 10b of the pin jig 10, we will describe a case when an operator inspects manually with reference to a flowchart in FIG. 13, by means of a flowchart in FIG. 13. At this time an automatic/manual change-over button 16a of the operating switch unit 16 is set to amanual side and an inspection step will be proceeded by an up-button 16b, a down-button 16c and a reset-button 16d.

At first plurality of measured values of a predetermined inspection will be read (Step S30). At a Step S31, an operator judges whether or not the read values intervenes within the predetermined areas. When intervening within the predetermined areas at the Step S31, the process proceeds to the next inspection Step S32. When not intervened within the predetermined area, the operator handles a button of the operational switch 16 (Step S33).

An operator judges whether or not the up button 16b is pushed down (Step S34). When the up button 16b is pushed, the process shifts to Step S30 to handle are inspection. Then, the operator judges whether nor not the Reset button 16d has been pushed down (Step S35) and when the Reset button 16d has been pushed, the printed-circuit board is referred to as NO GOOD (Step S36).

In this example, the digital signal processor (DSP) 10 feeds a predetermined inspection signal to predetermined test points on the printed-circuit board 2, which is an inspected product, in response to a command issued from the inspection program recorded in the CD-ROM 12 and run in the personal computer 11. A result-of-inspection signal (abbreviated by an inspected signal) is then acquired. It is judged from the inspected signal whether the printed-circuit board 2 is acceptable. Automatic measurement and automatic judgment are possible, and automatic inspection is possible. An incorrect judgment will not be made, and an operator's fatigue will be limited.

Moreover, the inspection apparatus performs inspection according to the inspection program. When objects of inspection are switched or inspection items are changed, the inspection program should merely be changed to another. It takes little time. Besides, no measuring instrument is needed, and only a small space is therefore needed.

In the above example, a case where a printed-circuit board for audio instruments is inspected is described. However, the present invention is not limited to the aforesaid example but can be modified without a departure from the gist of the invention.

First of all, the present invention can be applied not only to an inspection of a printed-circuit board, but also to an inspection of a device body. That is to say, in place of a pin jig for inspecting the printed-circuit board, a unit for connecting to an input/output terminal, a signal generator for remote control or a button-push jig are prepared for control and for checking the characteristics at each operational mode.

Further, the present invention can be applied not only to audio devices, but also a body or substitutes of a television set. That is, it can be applied not only to checking for a power source and a voice, but also to an adjuster for an image and focus, and for a white balance. For this reason, a video signal generator and a measuring unit are arranged on the DSP unit 11 and an output of an image pickup unit which captures images or a CRT is connected to a DSP unit 11. An image signal processor unit is provided on the DSP device 11 and a picture image, a focus and white-balance can be regulated.

The present invention is applicable to a body and substrate of a video deck (VCR), a video camera and a camera block. In this case, if a video signal generator and its measuring unit are provided with the DSP unit 11, the present invention is applicable to frequency checking of a white peak and sink chip, jitter measurement, or autofocus adjustment or white balancing of a video camera.

Except for the above device, in multifarious electronic devices such as an information equipment such as a personal computer (PC) and a communication equipment such as a telephone set, a measurement and inspection of a body and substrate of the electronic devices can be executed.

In the devices other than the above electronic devices sensors are inserted to a muffler, injection part, engine or the like, an interface substrate of the sensor can be inserted to the DSP device 11. Further, the present device is applicable to the measurement and inspection for the industrial devices such as automobiles or medical devices.

In the present invention device, a substrate necessary for a signal generation and a measurement is applied to the DSP device 11, while a program for measurement and inspection is fed to a personal computer 12 by a CD-ROM 13. As the case stands, an inspection of a body or a substrate of many devices can be executed in a simple way.

In the device according to the present invention, when a body or substrate of device is inspected, a subject to be inspected is contacted to a printed-circuit board directly by a pin-jig, is connected for inputting or outputting of a signal of a printed-circuit board or a remote-controlled signal (that is, so-called SIRCS signal) is applied to perform a mode change-over or inputting/outputting of a signal. Of course, the present invention is not limited to this method. A substrate for interface protocol which is defined by the IEEE-1394, can be mounted on the DSP unit 11, and connected with a measured device, there by communicating a data signal or control signal. If such interface protocol is used, there is a merit that a communication of control and data can be performed by only code connection.

Further, in the case of measuring subject in response to a wireless interface protocol which is defined by 820-11B or 820-11A, a board corresponding to the above subject may be provided with the DSP unit 11.

In the above description, CD-ROM 13 is used as a record media in which the inspection program is recorded, and the CD-ROM 13 is entered directly to a personal computer 12 to execute reading. But the present invention is not limited to this. For example, this personal computer 12 is connected with another personal computer (master computer) and a network and an inspection program which is recorded in a record media of the master computer can be sent to the personal computer 12 of the present invention via a network. Further, the program can be supplied such that a downloading from the master computer to the present personal computer 12 is effected via a communication means such as an Internet. When the program is fed from the master computer, it is advantageous that if the program is fed from the master computer, the program could be easily modified.

Identification information (ID) is provided separately to the personal computer 12 or the DSP unit 11 according to the present invention and ID is provided to CD-ROM or a program fed by a master computer. At first, acknowledge ID, and then the program can be input. Even if the characteristics of inspection unit caries a little by the date, the most suitable program for individual inspection unit is fed and the inspection unit can be run by this program.

Further, as the program is fed to the inspection unit from CD-ROM 13 and the master computer, there is no need to post a staff preparing a program in the field of direct manufacturing. That is, the staffs who make some programs is gathered at one place and the program for all factories can be made here. When the program making section or the production technique section is concentrated at a place, a skill of the program production is raised and when rejected goods or non-conformity occurs, counter measure to be solved can be fed to the place where non-conformity does not occur yet. Thereby, it is possible to prevent such case in advance.

By confining the inspection program with a master computer by a network and communication means, a result of work or data which is performed by this program may be reported to the master computer form the personal computer. At the beginning an operator checks whether the device is normal or not by a test signal and if possible, a calibration of the measured part is effected. The checked result and data of calibration method, the result of inspection and its contents, data of inspected quantity or the like are sent to the master computer at a predetermined time. The master computer processed the result or data statistically, that is to say, even if it is data within an allowable range, when a dispersion trends to increase, an operator considers a counter measure. As a result, an upper limit lower limit of the inspection or parameters are modified. Then, the changed parts of the program or the whole program are sent to the personal computer in charge. Then, an optimally modified program is sent to each inspection unit to operate. We described that a communication between a personal computer and a master computer is carried out between an end of work and a beginning time of work. But the real operator is not limited to this and, for example, it may be set to an interval between the recesses or it may be run simultaneously during a working time. As set to an arbitrary time, communication expenses can be deleted.

Based on a non-conforming of the inspection device, when the work stops in the field of manufacturing and an emergency occurs, a notification will be sent from the personal computer to the master computer to automatically ask for an urgent help from the program production section. Thus, a quick response and countermeasure are possible.

Based on a record of communication between computers, a program production section may charge fees from the manufacturing section. In this case, a predetermined fee regarding each maintenance work may be piled up, or a finite fee is charged regarding an ordinary work content and a fee on a special work may be added and charged as an additional charge. If the program production section or the productive technique section is used to charge a maintenance fee in a manufacturing field, it will be not necessary to possess individually a program production section or productive technique section in the manufacturing field and each section can be absorbed in manufacturing work. Between the above two sections, the same program can be made in the lump in an optional condition and the follow in a more effective and higher technique is possible by means of an independent finance system.

Moreover, the present invention is not limited to the aforesaid example but, of course, can be modified without a departure from the gist of the invention.

According to the present invention, a digital signal processor (DSP) feeds a predetermined inspection signal to predetermined points on an inspected product in response to a command issued from a personal computer, and acquires a result-of-inspection signal. It is judged from the result-of-inspection signal whether the inspected product is acceptable. Automatic measurement and automatic judgment are possible, and automatic inspection is possible.

Having described preferred embodiments of the present invention with reference to the accompanying drawings, it is to be understood that the present invention is not limited to the above-mentioned embodiments and that various changes and modifications can be effected therein by one skilled in the art without departing from the spirit or scope of the present invention as defined in the appended claims.

## Claims

1. An inspection apparatus comprising:
a recording medium in which an inspection program is recorded;
a personal computer in which the inspection program recorded in the recording medium is executed;
a digital signal processor (DSP) having its action controlled based on a command issued from the personal computer, feeding a predetermined inspection signal to predetermined points on an inspected product, and acquiring a result-of-inspection signal, it being judged from the result-of-inspection signal whether the inspected product is acceptable; and
a display device on which the result of judgment is displayed.

2. An inspection apparatus according to Claim 1 wherein
the contents of inspection and the situation thereof are displayed on said display device during inspection of said inspected product.

3. An inspection apparatus according to Claim 1 or 2 wherein
when it is judged that said inspected product is defective, the defect is displayed on said display device to thereby issue a warning.

4. An inspection apparatus according to Claim 1, 2 or 3 wherein
it can be automatically judged whether said inspected product is acceptable, and it can be manually judged whether said inspected product is acceptable.

5. An inspection apparatus according to any one of claims 1 to 4, wherein
a measured value concerning said inspected product is displayed on said display device in both an analog form and a digital form.
